# EUROPEAN PATENT APPLICATION

(11) **EP 4 582 990 A1**
(43) Date of publication of application: **09.07.2025**
(21) Application number: 25150255.5
(22) Date of filing: 03.01.2025
(51) Int. Cl.: G06F 30/13, G06F 30/20

(54) **METHODOLOGY TO USE SYSTEM MODELING LANGUAGE FOR QUANTIFYING STRUCTURAL COMPLEXITY OF A SYSTEM**

(30) Priority: 04.01.2024 US 202418403846
(71) Applicant: Hamilton Sundstrand Corporation, Charlotte, NC 28217-4578 (US)
(72) Inventor: MADHIVANAN, Gautam, Somerville, 02145 (US)
(74) Representative: Dehns

(57) **Abstract**

A structural complexity analysis system (100) includes a system modeling language (SysML) module (200) and a numerical computation module (202). The SysML module determines a complexity interaction profile of an engineering system, which includes a plurality of nodes and a plurality of connectors, each connector establishing a connection between a sub-set of nodes among the plurality of nodes, and determines a complexity node profile of parts, which defines a complexity of at least one node among the plurality of nodes. The SysML module (200) further generates an interfaces table based on the complexity interaction profile, and generates generate a node table based on the complexity node profile. The numerical computation module (202) receives the interfaces table and the node table, and applies at least one numerical computation tool to the interfaces table and the node table to determine an overall structural complexity of the engineering system.

## Description

### BACKGROUND

The embodiments herein relates generally to systems engineering, and more particularly, to a methodology to use system modeling language for quantifying structural complexity of a system.

Quantitative measurement methodologies have been developed to assess the structural complexity and characterization of engineered complex systems. One such methodology to quantify the complexity of an engineered system utilizes an equation, which defines complexity (C) as: C= C1+C2*C3, where C1 is the number of heterogeneous components, C2 is the number heterogenous interaction, and C3 is complexity due to topological formation. Since C1 and C2 are sums, factors can be added to supplement the understanding of complexity to show that some components or connections are more complex than others.

### BRIEF SUMMARY

According to a non-limiting embodiment a structural complexity analysis system includes a system modeling language (SysML) module and a numerical computation module. The SysML module is configured to: determine a complexity interaction profile of an engineering system, the complexity interaction profile including a plurality of nodes and a plurality of connectors, each connector establishing a connection between a sub-set of nodes among the plurality of nodes; determine a complexity node profile of parts, the complexity node profile defining a complexity of at least one node among the plurality of nodes; generate an interfaces table based on the complexity interaction profile; and generate a node table based on the complexity node profile. The numerical computation module is configured to receive the interfaces table and the node table from the SysML module; and apply at least one numerical computation tool to the interfaces table and the node table to determine an overall structural complexity of the engineering system.

In addition to one or more aspects of the system, or as an alternate, the numerical computation module computes a structural complexity value indicating the overall structural complexity in response to applying the at least one numerical computation tool.

In addition to one or more aspects of the system, or as an alternate, the numerical computation module generates a complexity graph indicative of the overall structural complexity in response to applying the at least one numerical computation tool.

In addition to one or more aspects of the system, or as an alternate, the SysML module creates the complexity interaction profile by applying a design structure matrix (DSM) connection stereotype to one or more of the connectors to define a type of the connection between the sub-set of nodes.

In addition to one or more aspects of the system, or as an alternate, the complexity node profile includes at least one stereotype that defines the complexity of the at least one node.

In addition to one or more aspects of the system, or as an alternate, the at least one stereotype is applied to one or more of states, part properties, and blocks included in the engineering system to define the complexity of the at least one node.

In addition to one or more aspects of the system, or as an alternate, the stereotype includes an attribute that sets the type of complexity for the at least one node.

In addition to one or more aspects of the system, or as an alternate, the attribute includes at least one of software lines of code (SLOC), technology readiness level (TRL), and a number of functions (NoFs).

In addition to one or more aspects of the system, or as an alternate, the interfaces table indicates opposing nodes for each of the connections of the engineering system, and the connection type for each of the connections of the engineering system; and the node table indicates different part properties, blocks, or states used in all of the connections of the engineering system, an individual complexity value indicating a complexity for the connections of the engineering system; and a type of complexity used for each of the connections of the engineering system.

In addition to one or more aspects of the system, or as an alternate, the structural complexity value ranges from a first value indicating a minimum overall complexity to a second value greater than the first value, the second value indicating a maximum overall complexity.

According to another non-limiting embodiment, a method of determining a structural complexity of an engineering system comprises determining, by a system modeling language (SysML) module, a complexity interaction profile of an engineering system. The complexity interaction profile includes a plurality of nodes and a plurality of connectors, each connector establishing a connection between a sub-set of nodes among the plurality of nodes. The method further comprises determining, by the SysML module, a complexity node profile of parts included in the engineering system. The complexity node profile defines a complexity of at least one node among the plurality of nodes. The method further comprises generating by the SysML module an interfaces table based on the complexity interaction profile, and a node table based on the complexity node profile. The method further comprises outputting the interfaces table and the node table from the SysML module to a numerical computation module, and applying by the numerical computation module at least one numerical computation tool to the interfaces table and the node table to determine an overall structural complexity of the engineering system.

In addition to one or more aspects of the method, or as an alternative, the method further comprises outputting the determined overall structural complexity of the engineering system to a user interface.

In addition to one or more aspects of the method, or as an alternative, the method further comprises computing by the numerical computation module a structural complexity value indicating the overall structural complexity in response to applying the at least one numerical computation tool.

In addition to one or more aspects of the method, or as an alternative, the method further comprises generating, by the numerical computation module, a complexity graph indicative of the overall structural complexity in response to applying the at least one numerical computation tool.

In addition to one or more aspects of the method, or as an alternative, the method further comprises creating, by the SysML module, the complexity interaction profile by applying a design structure matrix (DSM) connection stereotype to one or more of the connectors to define a type of the connection between the sub-set of nodes.

In addition to one or more aspects of the method, or as an alternative, the complexity node profile includes at least one stereotype that defines the complexity of the at least one node.

In addition to one or more aspects of the method, or as an alternative, the at least one stereotype is applied to one or more of states, part properties, and blocks included in the engineering system to define the complexity of the at least one node.

In addition to one or more aspects of the method, or as an alternative, the stereotype includes an attribute that sets the type of complexity for the at least one node.

In addition to one or more aspects of the method, or as an alternative, the attribute includes at least one of software lines of code (SLOC), technology readiness level (TRL), and a number of functions (NoFs).

In addition to one or more aspects of the method, or as an alternative, the interfaces table indicates opposing nodes for each of the connections of the engineering system, and the connection type for each of the connections of the engineering system; and the node table indicates different part properties, blocks, or states used in all of the connections of the engineering system, an individual complexity value indicating a complexity for the connections of the engineering system; and a type of complexity used for each of the connections of the engineering system.

In addition to one or more aspects of the method, or as an alternative, the structural complexity value ranges from a first value indicating a minimum overall complexity to a second value greater than the first value, the second value indicating a maximum overall complexity.

### BRIEF DESCRIPTION OF THE DRAWINGS

The present disclosure is illustrated by way of example and not limited in the accompanying figures in which like reference numerals indicate similar elements.
FIG. 1 is a high-level system diagram illustrating a computing system 10 including a structural complexity analysis system according to a non-limiting embodiment of the present disclosure;
FIG. 2 is a block diagram illustrating a structural complexity analysis system according to a non-limiting embodiment of the present disclosure; and
FIG. 3 is a flow diagram illustrating a method of analyzing a structural complexity of an engineering system according to a non-limiting embodiment of the present disclosure.

### DETAILED DESCRIPTION

Aspects of the disclosed embodiments will now be addressed with reference to the figures. Aspects in any one figure is equally applicable to any other figure unless otherwise indicated. Aspects illustrated in the figures are for purposes of supporting the disclosure and are not in any way intended on limiting the scope of the disclosed embodiments. Any sequence of numbering in the figures is for reference purposes only.

Turning to a description of technical aspects that are relevant to the teachings of the present disclosure, quantitative measurement methodologies require system information to be obtained and input into the complexity calculation (e.g., C= C1+C2*C3) to compute the overall complexity of the engineering system to be assessed. Some known quantitative measurement methodologies utilize a design structure matrix (DSM) to input the system information. DSMs, however, are not implemented in traditional systems engineering products. Therefore, a significant amount of separate work is required to integrate DSMs with known quantitative measurement methodologies. Furthermore, current methods of obtaining the system information involves manually extracting the data of the engineering system design (e.g., from the system piece parts list), but does not allow for assigning additional complexity details to a given part. Consequently, the calculated overall complexity may lack accuracy and precision.

As previously mentioned, the use of a design structure matrix (DSM) alone to input the system information is problematic because DSMs are not implemented in traditional systems engineering products. System Modeling Language (SysML), however, is a methodology already being implemented by the systems engineering discipline to perform Model Based Systems Engineering (MBSE). SysML is a graphical modeling language, which supports the specification, analysis, design, verification and validation of a broad range of complex engineering systems and systems-of-systems. SysML models can be used to generate tables or other artifacts through various tools and software that support SysML. These tables often represent different aspects of the system, such as requirements, components, or relationships, and they provide a structured and tabular view of the information contained within the SysML model.

Various non-limiting embodiments of the present disclosure overcome the shortcomings of traditional quantitative measurement methodologies by providing a structural complexity analysis system implements SysML using a SysML module, along with a numerical computation module such as, for example, Matlab. The structural complexity analysis system leverages the information entered into SysML to facilitate calculation of the system's complexity. According to a non-limiting embodiment, the structural complexity analysis system allows system data to be entered into the SysML model, which captures the complexity of the individual system nodes. The input information is then exported to the numerical computation tool, which captures the topological complexity of the system and generates a complexity graph showing the topological complexity and/or an overall structural complexity value indicating the overall structural complexity of the assessed system. In one or more non-limiting embodiments, the structural complexity analysis system allows for proper usage of the SysML methodology including nested components and port allocation, and also allows for outputting of a design structure matrix with specification of the connections.

Because SysML is a standard implementation of the systems engineering process, a user is able to quantify the structural complexity of a complex systems engineering system compared to conventional quantitative measurement methodologies. For example, the output generated by a non-limiting embodiment of the method is single number that can be easily added to trade studies. The method described according to embodiments herein can also automatically output a design structure matrix which is the input for existing methods. This methodology lives with the design, so updates can be easily implemented within less than an hour. This allows for adding more details to complexity quant as needed.

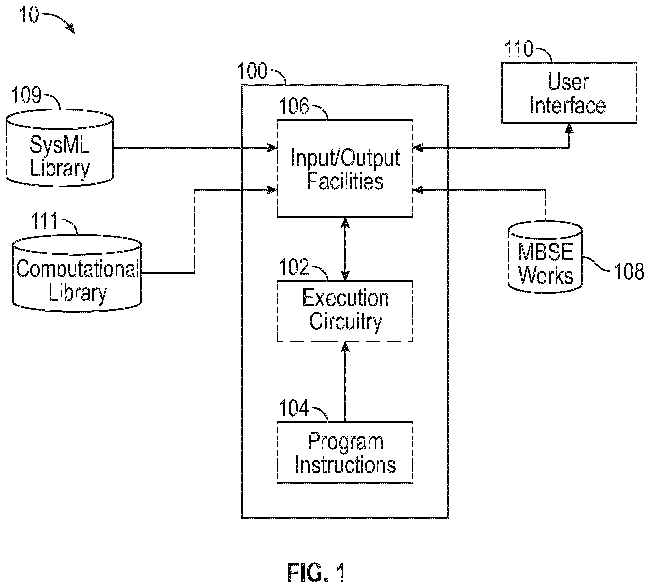

With reference now to FIG. 1, a high-level system diagram illustrating a computing system 10 implementing a structural complexity analysis system 100. The structural complexity system 100 is in signal communication with a user interface 110, a MBSE works library 108, a system model language (SysML) library 109, and a computational library 111.

The structural complexity analysis system 100 includes execution circuitry 102, such as one or more processors, memory, system interconnects, and the like, examples of which are described in greater detail below. The program instructions 104 are stored on a tangible, non-transitory, storage medium, such as a memory device, non-volatile memory, hard drive, solid-state drive, or the like, which is interfaced with execution circuitry 102.

The input/output facilities 106 are interfaced with execution circuitry 102, and are configured to facilitate the transmission of information from and to computational accelerator system 100. The input/output facilities 106 can establish data exchange between the execution circuitry 102, the user interface 110, the MBSE works library 108, the system model language (SysML) library 109, and the computational library 111.

The MBSE works library 108 stores one or more MBSE works in a respective tangible storage medium such as a file, collection of files, database, or other data structure, and accessible by the structural complexity analysis system 100 via input/output facilities 106. In addition, the MBSE works library 108 can store various stereotypes. The stereotype can be used to assign default attributes (e.g., highlighting, colors, etc.) and/or add specific properties (tagged values) to SysMI, blocks. In one or more non-limiting embodiments, the MBSE works library 108 can facilitate gathering information created by the SysML.

The structural complexity analysis system 100 reads MBSE works library 108, processes their contents to determine linkages between them, and presents the determinations to the user interface 110. In one or more non-limiting embodiments, the structural complexity analysis system 100 includes one or more access-control provisions to facilitate accessing MBSE works that are secured, such as via cryptography, access credential, or other suitable means. In a related example, the structural complexity analysis system 100 is configured to convert certain MBSE document types into a different format, or to import (e.g., selectively copy a subset of the content) from certain types of MBSE works. For example, graphical MBSE works such as engineering drawings or diagrams may be imported as text documents.

The SysML library 109 stores different SysML tools and software applications which support various functions of the Systems Modeling Language. The Accordingly, the SysML tools and software applications can be used to define the engineering system that is being modeled. Likewise, the computational library 111 stores various computational tools including, but not limited to, a statistics and machine learning toolbox, a curve fitting toolbox, a control system toolbox, a signal processing toolbox, a mapping toolbox, a datafeed toolbox, a financial toolbox, and a dsp system toolbox. The various computational tools can be utilized by a numerical computation module such as, for example, Matlab.

The user interface 110 is interfaced with the structural complexity analysis system 100 via input/output facilities 106. The user interface 110 can be hosted on the same machine as the structural complexity analysis system 100, or it may be hosted on a remote device that is communicatively coupled to the structural complexity analysis system 100 via a data-communication network such as, for example, a cloudcomputing network (not shown).

When executed by the processing circuitry 102, program instructions 104 create a special-purpose machine that embodies a structural complexity analysis system 100. Accordingly, the program instructions 104 and the execution circuitry 102 can establish a SysML module that uses SysML and can establish a numerical computation module that performs numerical computations assess an overall structural complexity of a complex engineering system. The structural complexity analysis system 100 can be implemented as a physical machine, or can be distributed among multiple physical machines, such as by role or function, or by process thread in the case of a cloud computing distributed model. In various embodiments, aspects of the invention may be configured to run in virtual machines that in turn are executed on one or more physical machines. It will be understood by persons of skill in the art that features of the invention may be realized by a variety of different suitable machine implementations.

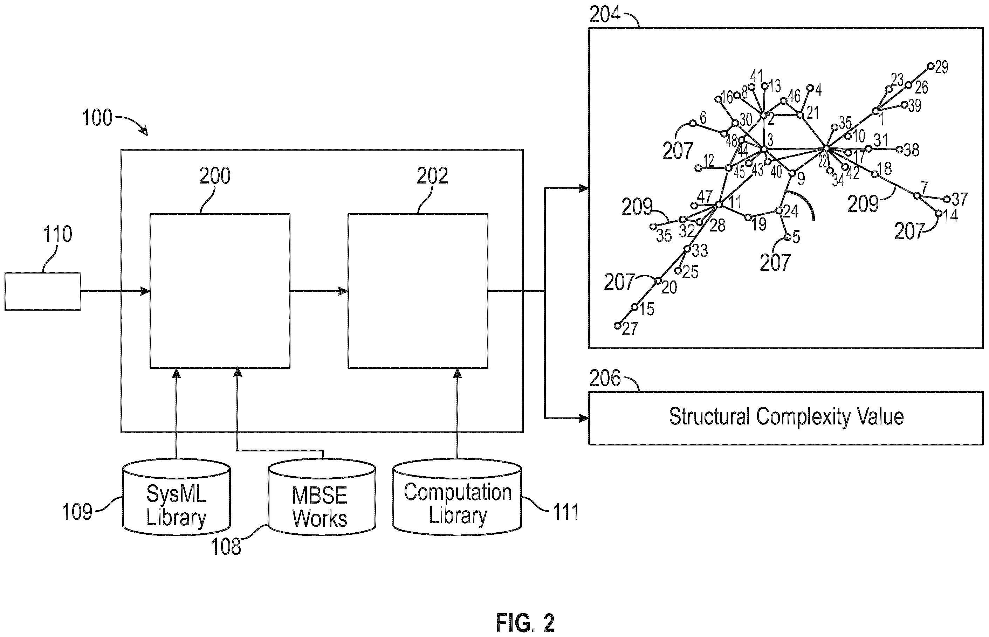

Turning to FIG. 2, a structural complexity analysis system 100 is illustrated according to a non-limiting embodiment of the present disclosure. The structural complexity analysis system 100 includes a SysML module 200 and a numerical computation module 202. As described herein, the SysML module 200 and the numerical computation module 202 can be implemented by executing, via the execution circuitry 102 program instructions 104 stored on a tangible, non-transitory, storage medium.

SysML is adept at managing and analyzing systems, enabling the representation and analysis of diverse aspects of systems through its versatile modeling elements. SysML "blocks" serve as modular units that encapsulate system components, both physical and conceptual. "Part properties" within these blocks detail the system's composition, illustrating how components integrate and interact. "Connectors" in SysML establish pathways for interactions between parts, conveying information, energy, or material flows. SysML "states" depict the various conditions or phases of a system component, essential for modeling dynamic behavior in state machine diagrams, while "transitions" are used to change between various states. SysML "stereotypes" extend the capabilities of standard elements like states by adding tailored properties or behaviors to fit specific modeling needs. A "node" can refer to elements in a network or system, particularly in the context of hardware or deployment diagrams. According to a non-limiting embodiment, a node can represent a physical entity in a system such as, for example, a computer, a network device, or other hardware components. Nodes and edges are common terminology in graph theory to depict elements in a system and their connections respectively.

As described herein, the SysML module 200 receives input data describing an engineering system to be analyzed and executes various SysML tools and applications obtained from the SysML library to generate a graphical SysML model, which captures the complexity of the system elements such as, for example, individual nodes and connectors which connect nodes of the engineering system. According to a non-limiting embodiment, the SysML module 200 receives input data from the user interface 110 to create a complexity interaction profile and a complexity node profile, which together define the engineering system to be analyzed. The complexity interaction profile applies one or more DSM connection stereotypes (e.g., from the MBSE works library 108) to connectors in order to define the type of connection (e.g. physical connection, fluid connection, informational connection, electrical connection). The DSM connection stereotype also contains endpoint definitions (e.g., EndA and EndB), which define a given connector.

The complexity node profile contains a stereotype for states, part properties, or blocks to define the complexity of the individual nodes. The stereotype contains an attribute that can be used to set the type of complexity used for the individual element. The type of complexity used can include, but is not limited to, software lines of code (SLOC), technology readiness level (TRL), and a number of functions (NoFs). According to a non-limiting embodiment, "function" is referred to as an activity or sequence performed to achieve a desired outcome. In this manner, for a given system element, part, node and/or connection, a user can select the type of part complexity (e.g., SLOC, TRL, Number of Function) displayed by the SysML using the user interface 110. According to a non-limiting embodiment, the values associated with a type of part complexity (e.g., 1 indicating a lowest complexity through 10 indicating a highest complexity) are hardcoded with a preset value indicating a level of complexity. Accordingly, a user selecting the complexity type to be used automatically sets the relevant value to be used to calculate the complexity for a given node and/or connection.

Using the complexity interaction profile and the complexity node profile, the SysML module 200 can generate complexity tables to communicate the information between the SysML model and the numerical computation module 202. According to a non-limiting embodiment, the complexity tables include an interfaces table generated according to the complexity interaction profile and a node table generated according to the complexity node profile. The interfaces table lists the elements on both ends of all the interfaces of the system as well as the connection type. For SysML connectors that are connected to ports or to the external boundaries of a diagram, the state, part property, or block is listed (as opposed to the port). The node table lists the different elements used in the model. In one or more non-limiting embodiments, the different elements are on the ends of the interfaces. Additionally, the node table lists a part value to be used to calculate complexity for a given node, and/or connection, and the type of complexity associated with the node and/or connection

In one or more non-limiting embodiment, the complexity tables can be synched with the numerical computation module 202 so that changes to the model in the SysML module 200 can quickly have their complexity computed by numerical computation module 202. For example, the MBSE works library 108 can gather information generated by the SysML module 200 (e.g., using SysML) to generate the complexity tables such that the complexity tables can then be exported to the numerical computation module 202. The computation module 202 can then apply one or more computational tools obtained from the computation library 111. According to a non-limiting embodiment, the numerical computation module 202 selects the interfaces table, and the nodal table to generate a program script. the numerical computation module 202 can then execute the program script to generate a complexity graph 204 showing the topological complexity of the engineering system and compute a structural complexity value 206 indicating the overall structural complexity of the engineering system. According to a non-limiting embodiment, the complexity graph 204 is a network diagram where circles represent nodes 207 of the engineering system, reference numerals identifying a given node, and lines 209 representing connections between nodes 207.

According to a non-limiting embodiment, the structural complexity value 206 is a value greater than one, which is indicative of the overall structural complexity of the engineering system. For example, a system with just one node and no connections could theoretically have a complexity of 1, while theoretically a systems with infinite nodes and connection could have a structural complexity of infinity. Comparing the complexity value 206 derived from multiple systems, or one system as it changes would indicate which of the two systems is more complex than the other.

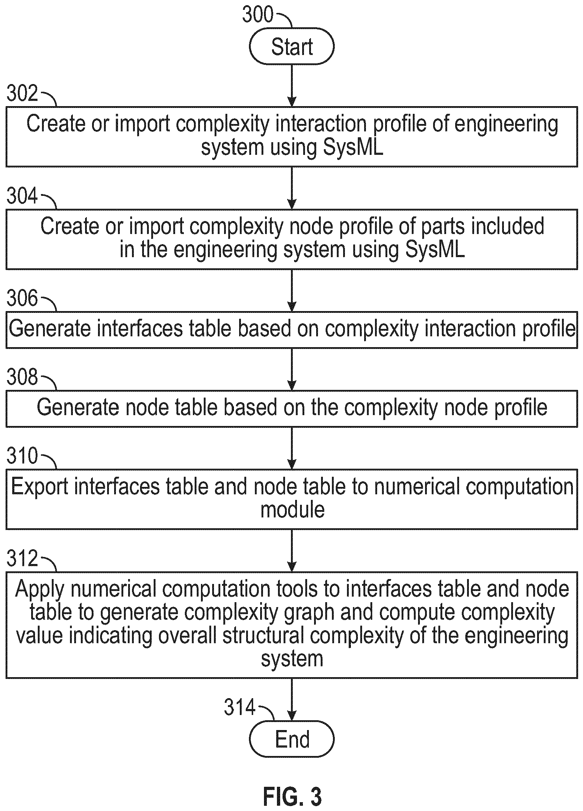

Turning now to FIG. 3, a method of analyzing a structural complexity of an engineering system is illustrated according to a non-limiting embodiment of the present disclosure. The method begins at operation 300, and a complexity interaction profile of engineering system is determined, e.g., imported (e.g., from a database or memory) or created using a SysML at operation 302. At operation 304, a complexity node profile of parts included in the engineering system is determined, e.g., imported or created using SysML. At operation 306, an interfaces table is created (e.g., using SysML) based on the complexity interaction profile. At operation 308, an node table is created (e.g., using SysML) based on the complexity node profile. At operation 310, the interfaces table and the node table are exported to a numerical computation module (e.g., Matlab). At operation 312, the numerical computation module applies one or more numerical computational tools to the interfaces table and the node table to generate a complexity graph and to compute a structural complexity value indicating the overall structural complexity of the engineering system, and the method ends at operation 314.

As described herein, a structural complexity analysis system implements a SysML module and a numerical computation module to facilitate calculation of an engineering system's complexity. The structural complexity analysis system allows system data to be entered into the SysML model, which captures the complexity of the individual system nodes. The input information is then exported to the numerical computation tool, which captures the topological complexity of the system. The structural complexity analysis system facilitates proper usage of the SysML methodology including nested components and port allocation, and allows for outputting of a design structure matrix with specification of the connections to generate a complexity graph and/or an overall structural complexity value indicating the overall structural complexity of the assessed system.

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

Those of skill in the art will appreciate that various example embodiments are shown and described herein, each having certain features in the particular embodiments, but the present disclosure is not thus limited. Rather, the present disclosure can be modified to incorporate any number of variations, alterations, substitutions, combinations, sub-combinations, or equivalent arrangements not heretofore described, but which are commensurate with the scope of the present disclosure. Additionally, while various embodiments of the present disclosure have been described, it is to be understood that aspects of the present disclosure may include only some of the described embodiments. Accordingly, the present disclosure is not to be seen as limited by the foregoing description, but is only limited by the scope of the appended claims.

## Claims

1. A structural complexity analysis system (100) comprising:
a system modeling language, SysML, module (200) configured to:
determine a complexity interaction profile of an engineering system, the complexity interaction profile including a plurality of nodes and a plurality of connectors, each connector establishing a connection between a sub-set of nodes among the plurality of nodes;
determine a complexity node profile of parts included in the engineering system, the complexity node profile defining a complexity of at least one node among the plurality of nodes;
generate an interfaces table based on the complexity interaction profile; and
generate a node table based on the complexity node profile;
a numerical computation module (202) in signal communication with the SysML module, the numerical computation module configured to:
receive the interfaces table and the node table from the SysML module;
apply at least one numerical computation tool to the interfaces table and the node table to determine an overall structural complexity of the engineering system.

2. The structural complexity analysis system of claim 1, further configured to output the determined overall structural complexity of the engineering system to a user interface (110).

3. The structural complexity analysis system of claim 1 or 2, wherein the numerical computation module is configured to compute a structural complexity value indicating the overall structural complexity in response to applying the at least one numerical computation tool; and/or
wherein the numerical computation module is configured to generate a complexity graph indicative of the overall structural complexity in response to applying the at least one numerical computation tool; and/or
wherein the SysML module is configured to create the complexity interaction profile by applying a design structure matrix, DSM, connection stereotype to one or more of the connectors to define a type of the connection between the sub-set of nodes.

4. The structural complexity analysis system of any preceding claim, wherein the complexity node profile includes at least one stereotype that defines the complexity of the at least one node.

5. The structural complexity analysis system of claim 4, wherein the at least one stereotype is applied to one or more of states, part properties, and blocks included in the engineering system to define the complexity of the at least one node.

6. The structural complexity analysis system of claim 4 or 5, wherein the stereotype includes an attribute that sets the type of complexity for the at least one node; and, optionally,
wherein the attribute includes at least one of software lines of code, SLOC; technology readiness level, TRL; and a number of functions, NoFs.

7. The structural complexity analysis system of any preceding claim, wherein:
the interfaces table indicates opposing nodes for each of the connections of the engineering system, and the connection type for each of the connections of the engineering system; and
the node table indicates different at least one of part properties, blocks, and states used in all of the connections of the engineering system, an individual complexity value indicating a complexity for the connections of the engineering system; and a type of complexity used for each of the connections of the engineering system.

8. The structural complexity analysis system of any preceding claim, wherein the structural complexity value ranges from a first value indicating a minimum overall complexity to a second value greater than the first value, the second value indicating a maximum overall complexity.

9. A method (300) of determining a structural complexity of an engineering system, the method comprising:
determining (302), by a system modeling language, SysML, module, a complexity interaction profile of an engineering system, the complexity interaction profile including a plurality of nodes and a plurality of connectors, each connector establishing a connection between a sub-set of nodes among the plurality of nodes;
determining (304), by the SysML module, a complexity node profile of parts included in the engineering system, the complexity node profile defining a complexity of at least one node among the plurality of nodes;
generating (306), by the SysML module, an interfaces table based on the complexity interaction profile; and
generating (308), by the SysML module, a node table based on the complexity node profile;
outputting (310) the interfaces table and the node table from the SysML module to a numerical computation module; and
applying (312), by the numerical computation module, at least one numerical computation tool to the interfaces table and the node table to determine an overall structural complexity of the engineering system.

10. The method of claim 9, further comprising outputting the determined overall structural complexity of the engineering system to a user interface (110).

11. The method of claim 9 or 10, further comprising computing by the numerical computation module a structural complexity value indicating the overall structural complexity in response to applying the at least one numerical computation tool; and/or
further comprising generating, by the numerical computation module, a complexity graph indicative of the overall structural complexity in response to applying the at least one numerical computation tool; and/or
further comprising creating, by the SysML module, the complexity interaction profile by applying a design structure matrix, DSM, connection stereotype to one or more of the connectors to define a type of the connection between the sub-set of nodes.

12. The method of any of claims 9 to 11, wherein the complexity node profile includes at least one stereotype that defines the complexity of the at least one node.

13. The method of any of claims 9 to 12, further comprising applying the at least one stereotype to one or more of states, part properties, and blocks included in the engineering system to define the complexity of the at least one node.

14. The method of claim 12 or 13, wherein the stereotype includes an attribute that sets the type of complexity for the at least one node; and, optionally,
wherein the attribute includes at least one of software lines of code, SLOC; technology readiness level, TRL; and a number of functions, NoFs.

15. The method of any of claims 9 to 14, wherein:
the interfaces table indicates opposing nodes for each of the connections of the engineering system, and the connection type for each of the connections of the engineering system; and
the node table indicates different at least one of part properties, blocks, and states used in all of the connections of the engineering system, an individual complexity value indicating a complexity for the connections of the engineering system; and a type of complexity used for each of the connections of the engineering system; and/or
wherein the structural complexity value ranges from a first value indicating a minimum overall complexity to a second value greater than the first value, the second value indicating a maximum overall complexity.
